Europäisches Patentamt

European Patent Office

Office européen des brevets

(11) Veröffentlichungsnummer: **0 499 052 A2**

## EUROPÄISCHE PATENTANMELDUNG

(21) Anmeldenummer: **92100906.4**

(22) Anmeldetag: **21.01.92**

(51) Int. Cl.5: **C23C 14/06**, C23C 16/30, C23C 14/20, C23C 16/06

(30) Priorität: **12.02.91 DE 4104198**

(43) Veröffentlichungstag der Anmeldung: **19.08.92 Patentblatt 92/34**

(84) Benannte Vertragsstaaten: **CH DE FR GB IT LI**

(71) Anmelder: **BASF Aktiengesellschaft Carl-Bosch-Strasse 38 W-6700 Ludwigshafen(DE)**

(72) Erfinder: **Harth, Klaus, Dr. Starenweg 6 W-6719 Altleiningen(DE)**
Erfinder: **Hibst, Hartmut, Dr. Branichstrasse 23 W-6905 Schriesheim(DE)**
Erfinder: **Peter, Roland, Dr. Pfalzring 92 W-6704 Mutterstadt(DE)**
Erfinder: **Wahle, Michael, Dr. Cuiserystrasse 7 a W-6706 Wachenheim(DE)**

(54) Verfahren zur Herstellung von Formteilen mit guten Oberflächeneigenschaften.

(57) Die Erfindung betrifft ein Verfahren zur Herstellung von Formteilen mit harten, verschleißfesten bzw. chemikalienbeständigen Oberflächen, bestehend aus

A. einem Grundkörper auf Basis eines faserverstärkten Kunststoffes, insbesondere eines Duroplasten und

B. einer Deckschicht auf Basis eines Metalls oder einer keramischen Metallverbindung, insbesondere von Wolframcarbid oder Chromnitrid.

Die Deckschicht wird auf den Grundkörper durch physikalische oder chemische Abscheidung aus der Dampfphase unter Vakuum (PVD- bzw. CVD-Verfahren) aufgebracht.

Die Formteile eignen sich als tribologisch stark beanspruchbare Bauteile eines Apparates oder einer Maschine.

EP 0 499 052 A2

Es ist bekannt, daß durch die Verwendung von Faserverbundwerkstoffen mit polymerer Matrix erhebliche Gewichtseinsparungen im Fahrzeug-, Flugzeug- und Maschinenbau erreicht werden können. Halbzeuge und Fertigteile auf der Basis von faserverstärkten Kunststoffen finden beispielsweise Verwendung als Kraftfahrzeugteile (z.B. Heckklappen, Bodengruppen oder Blattfedern), Flugzeugteile (z.B. Landeklappen, Seitenleitwerk oder Höhenruder) oder Maschinenteile (z.B. Fadengreiferstangen, oder Leichtwalzen). Ein gravierender Nachteil von derartigen Verbundwerkstoffteilen mit polymerer Matrix ist die geringe Oberflächenhärte, welche beim Einsatz entsprechender Bauteile in tribologisch beanspruchten Systemen zu einem schnellen Verschleiß des Bauteils durch Abrieb führt.

Das Verschleißverhaltens von Verbundwerkstoffkörpern kann bekanntlich durch Beschichtung mit einem widerstandsfähigen Metall verbessert werden. Nach DE-GM 84 06 019 wird eine Verbesserung der Abriebfestigkeit beispielsweise durch eine galvanische oder naßchemisch stromlose Abscheidung einer 10 bis 100 μm dicken Cr- oder Ni-Schicht erreicht. Die Haftfestigkeit solcherart abgeschiedenen Metallschichten ist jedoch nicht immer ausreichend. Insbesondere bei starker tribologischer Belastung erfolgt eine zumindest teilweise Ablösung der Schicht und die entsprechende Bildung von Abriebpartikeln. Darüber hinaus erfordert eine galvanische oder naßchemisch stromlose Herstellung der Deckschicht eine aufwendige und kostenintensive Entsorgung der benötigten Chemikalienbäder.

Weiterhin wurde vorgeschlagen (z.B. DE 35 27 912, DE 38 44 290), die Oberflächenhärte von Verbundwerkstoffen durch Auftragen einer metallischen oder keramischen Schicht mittels Plasma- oder Flammspritzen zu verbessern. Auch diese Schichten zeigen nur für ausgewählte Matrixsysteme eine befriedigende Haftung. In den meisten Fällen ist eine zusätzliche Zwischenschicht notwendig, die als Haftgrund oder Puffer bei der Plasma- oder Flammspritzbeschichtung dient. Desweiteren führt die hohe Temperaturbelastung des Grundkörpers bei derartigen Beschichtungsverfahren zu einer Beeinträchtigung der Formbeständigkeit und der Festigkeit des Grundkörpers, welcher nur durch eine aufwendige Kühlung des Grundkörpers entgegengewirkt werden kann. Auch in diesem Falle kann jedoch zumindest in oberflächennahen Bereichen des Grundkörpers eine Erweichung stattfinden, welche die Anwendungsmöglichkeiten insbesondere für Bauteile mit entsprechenden Maßhaltigkeitsanforderungen stark einschränkt.

Schließlich wurde auch schon beschrieben, daß harte, verschleißfeste Beschichtungen durch physikalische oder chemische Abscheidung aus der Dampfphase auf metallische Träger aufgebracht werden können, wobei im allgemeinen Temperaturen oberhalb von 300°C angewandt werden (siehe z.B. Surface and Coatings Technologie 37 (1989), S. 483-509, sowie Die Bibliothek der Technik, "Oberflächentechnik-Verschleißschutz, Band 38, Verlag Moderne Industrie, 1990). Eine direkte Übertragung dieser Techniken auf polymerhaltige Substrate scheiterte jedoch bisher stets an der mangelnden elektrischen Leitfähigkeit bzw. an der zu geringen Temperaturbeständigkeit der Kunststoff-Substrate.

Der Erfindung lag also die Aufgabe zugrunde, ein Formteil auf der Basis eines faserverstärkten Verbundwerkstoffes mit hoher Oberflächenhärte zu schaffen, welches sich durch eine hohe Verschleißfestigkeit, eine hohe Haftfestigkeit der Deckschicht sowie je nach Matrixharz durch eine gute Temperaturbeständigkeit des Verbundkörpers auszeichnet. Gleichzeitig sollte bei dem Beschichtungsverfahren die Nachteile der bisher bekannten Verfahren vermieden werden.

Diese Aufgaben werden erfindungsgemäß dadurch gelöst, daß man die Deckschicht auf den Grundkörper durch physikalische Abscheidung unter Vakuum aufbringt.

Gegenstand der Erfindung ist demzufolge ein Verfahren zur Herstellung von Formteilen mit guten Oberflächeneigenschaften, bestehend aus

A. einem Grundkörper auf Basis eines Kunststoffes und

B. einer Deckschicht auf Basis eines Metalls oder einer keramischen Metallverbindung, wobei die Deckschicht auf den Grundkörper durch physikalische oder chemische Abscheidung aus der Dampfphase unter Vakuum aufgebracht wird.

Die Kunststoffmatrix des Grundkörpers kann aus einem Thermoplasten oder einem Duroplasten bestehen. Bevorzugt sind faserverstärkte, gehärtete Kunstharze, z.B. solche auf Basis von ungesättigten Polyestern, ferner Vinylester- und Vinylesterurethanharze, Epoxidharze und Bismaleinimidharze, sowie Polyimide. Grundsätzlich sind auch Thermoplasten, wie Polyamide oder aromatische Polysulfone geeignet.

Als Verstärkungsfasern sind Kohlenstoff- und Glasfasern bevorzugt, grundsätzlich sind jedoch auch andere übliche Fasern, z.B. aus aromatischen Polyamiden und Polyethylen geeignet. Die Fasern können sowohl als Kurzfasern als auch als Langfasern vorliegen. Bevorzugt sind gerichtete Endlosfasern.

Die Herstellung der Grundkörper kann nach den in der Kunststofftechnologie üblichen Verfahren erfolgen, z.B. nach den Wickelverfahren, Harzinjektionsverfahren oder Preßverfahren. Auch das Aushärten wird nach üblichen Methoden vorgenommen.

Als Deckschichten eignen sich Metalle, z.B. Chrom, Molybdän, Titan und Legierungen des Typs Me-Cr-Al-Y (mit Me = Ni oder Co), sowie insbesondere keramische Metallverbindungen, z.B. Carbide, Nitride, Oxide, Silicide und Boride der obengenannten Metalle. Besonders bevorzugt sind Wolframcarbid und Chromnitrid. Die Deckschicht ist vorzugsweise 0,5 bis 20 $\mu$m dick.

Das Aufbringen der Deckschicht auf den Grundkörper erfolgt durch physikalische oder chemische Abscheidung unter Vakuum, in der Fachsprache als PVD(physical vapor deposition)- bzw. CVD(chemical vapordeposition)-Verfahren bekannt. Unter Vakuum ist dabei ein Druck von weniger als 10 mbar, insbesondere von weniger als 1 mbar zu verstehen. Bevorzugt sind Plasmaverfahren, wie Kathodenzerstäubung, Ionenplattierung, Arc-Beschichtung und Plasmapolymerisation, wobei die Kathodenzerstäubung besonders bevorzugt ist.

Bei der Kathodenzerstäubung ("sputtering") werden die zu beschichtenden Materialien in fester Form auf die Kathode des Plasmasystems aufgebracht, im Vakuum (vorzugsweise $5 \cdot 10^{-4}$ bis $5 \cdot 10^{-2}$ mbar) in einer Prozeßgasatmosphäre zerstäubt und auf dem vorher konditionierten Grundkörper abgeschieden. Üblicherweise enthält das Prozeßgas ein Edelgas wie Argon. Bei der reaktiven Kathodenzerstäubung werden dem Prozeßgas weitere reaktive Gase wie Wasserstoff, Kohlenwasserstoffe, Sauerstoff, Stickstoff u.a. in der gewünschten Menge zugemischt. Hierdurch kann man durch Zerstäuben von Metallen beispielsweise in der Gegenwart von Stickstoff im Prozeßgas direkt die betreffenden Metallnitridschichten abscheiden. Dabei können die Dicke, die Struktur und die Zusammensetzung der betreffenden Schichten über die Zerstäubungsrate, die Abscheiderate, den Prozeßgasdruck und die Prozeßgaszusammensetzung auf an sich bekannte Weise eingestellt werden.

Beim Ionenplattieren wird der zu beschichtende Körper mit einer in der Regel negativen Vorspannung (Bias) belegt, welche zu einem intensiven Beschuß des Formkörpers mit Ionen während der Beschichtung führt. Ein besonderer Effekt wird dann erzielt, wenn der Abtrag des festen Beschichtungsmaterials durch einen Plasmabogen geschieht (Arc-Beschichtung), welcher zu einem hohen Ionisationsgrad des Beschichtungsmaterials in der Prozeßgasatmosphäre führt.

Bei der Plasmapolymerisation wird das Beschichtungsmaterial in gasförmiger Form in die Reaktionszone geführt. Das Prozeßgas besteht dabei aus einem geeigneten Gemisch des gasförmigen Ausgangsmaterials und weiterer Inertgase, wie z.B. Ar. Die Herstellung der gewünschten Schicht geschieht in einem RF- oder Mikrowellen-induzierten Plasma durch Abscheidung des gasförmigen Vorläufers und anschließender Vernetzung.

Die erfindungsgemäßen Verfahren sollten bei verhältnismäßig niedrigen Temperaturen durchgeführt werden, d.h., die Temperatur der Substrate sollte 250°C, vorzugsweise 200°C nicht übersteigen, damit keine Schädigung erfolgt.

Bei einer bevorzugten Arbeitsweise wird der Grundkörper erst konditioniert, bevor die Deckschicht aufgebracht wird. Das Konditionieren erfolgt durch thermische Vorbehandlung des faserverstärkten Kunststoffs, z.B. durch Erwärmen auf Temperaturen von 80 bis 120°C während eines Zeitraums von 0,5 bis 3 Stunden. Im Anschluß daran kann dann noch eine Plasmavorbehandlung in einem elektrischen Wechselfeld (z.B. 13,6 MHz) durchgeführt werden. Die Kombination der beschriebenen Konditionierung mit der anschließenden Beschichtung führt zu wesentlich verbesserten Schichteigenschaften, wie Adhäsion und Stress.

In einer besonders bevorzugten Ausführungsform der Erfindung werden Deckschichten aus Wolframcarbid durch Kathodenzerstäubung auf einen Grundkörper aufgebracht. Ein Verfahren zur Herstellung von Wolframcarbid-Schichten ist in Appl. Phys. Lett. 50 (1987), 1055-1058 beschrieben, wobei als Grundkörper Silicium- oder Stahlsubstrate dienen. Die hohen Eigenspannungen der Schicht führen jedoch auf diesen Substraten zu einem schnellen Ablösen der Schicht aufgrund mangelnder Haftung. Auf den erfindungsgemäßen Grundkörpern wird dagegen überraschenderweise eine ausgezeichnete Substrathaftung unabhängig von den speziellen Sputterbedingungen gefunden.

Der besondere Vorteil der genannten Plasmaverfahren liegt darin, daß die Atome/Ionen des Beschichtungsmaterials mit hoher Energie auf den zu beschichtenden Grundkörper auftreffen. Die beim Auftreffen auf den Grundkörper freigesetzte Energie führt zu einer hohen Mobilität der Atome in der niedergeschlagenen Schicht und bewirkt die Bildung einer Schicht mit hoher Dichte und inniger Verzahnung mit dem Substrat. Letztere wird zusätzlich dadurch gesteigert, daß der zu beschichtende Grundkörper selbst dem Beschichtungsplasma und damit dem Beschuß mit Ladungsträgern (Ionen, Elektronen) sowie der im Plasma erzeugten Strahlung ausgesetzt ist. Die erfindungsgemäßen Schichten zeichnen sich daher durch eine sehr hohe Adhäsion sowie eine dichte Morphologie aus. Hierdurch wird die hohe Verschleißfestigkeit, die gute Chemikalienbeständigkeit sowie die Steigerung der thermooxidativen Stabilität des Formteils bewirkt.

Besonderes Kennzeichen der erfindungsgemäßen Formteile ist ihre große Härte, die hohe Dichte und die sehr hohe Haftfestigkeit der Oberflächenschicht. Die erfindungsgemäße Kombination eines Grundkörpers mit geringem spezifischem Gewicht und hoher Temperaturbeständigkeit und einer ausgezeichnet haftenden Deckschicht hoher Härte ermöglicht einen bisher nicht bekannten Einsatz solcher Verbundkörper als tribologisch beanspruchte Bauteile in Maschinen oder Apparaturen. Beipiele solcher Formkörper sind Gleitlagerelemente oder Zahnräder. Die erfindungsgemäßen Formkörper zeichnen sich gegenüber den bekannten Formkörpern aus metallischen Werkstoffen durch ein deutlich reduziertes Gewicht bei deutlich verbesserten gewichtsbezogenen mechanischen Eigenschaften, wie z.B. Elastizitätsmodul, Biegesteifigkeit und Strukturfestigkeit, aus. Gegenüber den bisher bekannten Bauteilen auf der Basis von Verbundwerkstoffen zeigen die erfindungsgemäßen Formteile deutlich verbesserte tribologische Standzeiten.

Beispiele

Beispiel 1

Ein plättchenförmiger Verbundkörper auf der Basis eines kohlenstoffaserverstärkten Bismaleinimidharzes wurde im Harzinjektionsverfahren (RTM) hergestellt und 2 Stunden lang auf 80 - 100 °C erwärmt. Der Verbundkörper wurde in eine Gleichspannungs-Kathodenzerstäubungsanlage eingesetzt. Parallel zu dem Verbundkörper wurde in einem Abstand von 60 mm ein festes Target bestehend aus Kohlenstoff und Wolfram eingesetzt. Die Vakuumkammer der Kathodenzerstäubungsanlage wurde auf ein Vakuum von $5 \times 10^{-7}$ mbar evakuiert. Danach wurde Ar-Gas bis zu einem Druck von $5 \times 10^{-3}$ mbar eingelassen. Der Grundkörper wurde durch Anlegen eines RF-Plasmas (Wechselfeld mit 13,6 MHz) mit einer Leistung von 0,5 kW während einer Dauer von 30 s konditioniert. Direkt danach wurde Ar bis zu einem Druck von $5 \times 10^{-2}$ mbar eingelassen und durch Anlegen einr DC-Spannung an das Target mit einer Zerstäubungsleistung von 500 W eine Wolframcarbid-Schicht der Zusammensetzung 96 At.-% C und 4 At.-% W mit einer Dicke von 3 $\mu$m abgeschieden.

Zur Bestimmung der Haftfestigkeit wurde die Schicht einem Schältest unterzogen. Schälversuche mit handelsüblichen Klebebändern (Scotch, EAA) führten stets zu einem Ablösen des Klebebandes von der Schicht, während die Schicht keine Ablösung von dem Grundkörper zeigte. Entsprechende Schältests zeigten das gleiche Ergebnis nach mehrmaligen zyklischen thermischen Belastungen (20 °C bis 100 °C) des Verbundkörpers.

Die Oberflächenhärte des Verbundkörpers wurde mit einem Härtemeßgerät nach Vickers bestimmt. Bei einer Belastung des Probekörpers mit 50 g wurde eine Härte von 2500 HV ermittelt. Vergleichende Untersuchungen des unbeschichteten Grundkörpers zeigten eine Härte von etwa kleiner 50 HV.

Das tribologische Verhalten des Verbundkörpers wurde mit einem Scratch-Tester nach Hintermann ermittelt. Dabei wurde eine Diamantkugel mit einem Radius von 0,8 mm in relativer Bewegung bei einer Vorschubgeschwindigkeit von 1 mm/s auf den Verbundkörper gedrückt. Die Belastung wurde dabei von 0 auf 100 N mit einer Steigung von 10 N/s erhöht. Bei mikroskopischer Untersuchung der Kratzspur zeigte der Verbundkörper keine sichtbaren Verschleißspuren für Belastungen unterhalb 60 N. Der Reibungskoeffizient betrug 0,1.

Beispiel 2

Beispiel 1 wurde wiederholt, wobei jedoch ein glasfaserverstärktes BMI-Harz verwendet wurde.

Die Oberflächenhärte des Verbundkörpers wurde mit einem Härtemeßgerät nach Vickers bestimmt. Bei einer Belastung des Probekörpers mit 50 g wurde eine Härte von 2500 HV ermittelt. Vergleichende Untersuchungen des unbeschichteten Grundkörpers zeigten eine Härte von kleiner 50 HV.

Beispiel 3

Ein plättchenförmiger Verbundkörper auf der Basis eines kohlenstoffaserverstärkten Bismaleinimidharzes wurde im Harzinjektionsverfahren (RTM) hergestellt. Der Verbundkörper wurde in eine Gleichspannungs-Kathodenzerstäubungsanlage eingesetzt. Parallel zu dem Verbundkörper wurde in einem Abstand von 60 mm ein festes Target bestehend aus Chrom eingesetzt. Die Vakuumkammer der Kathodenzerstäubungsanlage wurde auf ein Vakuum von $5 \times 10^{-7}$ mbar evakuiert. Danach wurde Ar-Gas bis zu einem Druck von $5 \times 10^{-3}$ mbar eingelassen. Der Grundkörper wurde durch Anlegen eines RF-Plasmas mit einer Leistung von 0,5 kW während einer Dauer von 30 s konditioniert. Direkt danach wurde Ar mit einem Gasfluß von 80 sccm und N2 mit einem Gasfluß von 40 sccm eingelassen. der Gesamtdruck wurde auf $3 \times 10^{-3}$ mbar eingestellt. Durch Anlegen einer DC-Spannung an das Target mit einer Zerstäubungsleistung von 500 W wurde eine CrN-Schicht mit einer Dicke von 5 um abgeschieden.

Zur Bestimmung der Haftfestigkeit wurde die Schicht einem Schältest unterzogen. Schälversuche mit handelsüblichen Klebebändern (Scotch, EAA) führten stets zu einem Ablösen des Klebebandes von der Schicht, während die Schicht keine Ablösung von dem Grundkörper zeigte. Entsprechende Schältests zeigten das gleiche Ergebnis nach mehrmaligen zyklischen thermischen Belastungen (20 °C bis 100 °C) des Verbundkörpers.

Die Oberflächenhärte des Verbundkörpers wurde mit einem Härtemeßgerät nach Vickers bestimmt. Bei einer Belastung des Probekörpers mit 50 g wurde eine Härte von 1000 HV ermittelt. Vergleichende Untersuchungen des unbeschichteten Grundkörpers zeigten eine Härte von kleiner 50 HV.

Das tribologische Verhalten des Verbundkörpers wurde mit einem Scratch-Tester nach Hintermann ermittelt. Dabei wurde eine Diamantkugel mit einem Radius von 0,8 mm in relativer Bewegung bei einer Vorschubgeschwindigkeit von 1 mm/s auf den Verbundkörper gedrückt. Die Belastung wurde dabei von 0 auf 100 N mit einer Steigung von 10 N/s erhöht. Bei mikroskopischer Untersuchung der Kratzspur zeigte der Verbundkörper keine sichtbaren Verschleißspuren für Belastungen unterhalb 100 N. Der Reibungskoeffizient betrug 0,1.

## Patentansprüche

1. Verfahren zur Herstellung von Formteilen mit guten Oberflächeneigenschaften, bestehend aus
   A. einem Grundkörper auf Basis eines Kunststoffes und
   B. einer Deckschicht auf Basis eines Metalls oder einer keramischen Metallverbindung,
   dadurch gekennzeichnet, daß die Deckschicht auf den Grundkörper durch physikalische oder chemische Abscheidung aus der Dampfphase unter Vakuum aufgebracht wird.

2. Verfahren nach Anspruch 1, dadurch gekennzeichnet, daß die Kunststoffmatrix des Grundkörpers ein faserverstärktes, ausgehärtetes Kunstharz ist.

3. Verfahren nach Anspruch 2, dadurch gekennzeichnet, daß das Kunstharz ein Polyesterharz, Vinylesterharz, Vinylesterurethanharz, Epoxidharz, Bismaleinimidharz oder ein Polyimid ist.

4. Verfahren nach Anspruch 1, dadurch gekennzeichnet, daß die Verstärkungsfasern des Grundkörpers Kohlenstoff-, Glas-, Aramid- oder Polyethylen-Fasern sind.

5. Verfahren nach Anspruch 1, dadurch gekennzeichnet, daß die Deckschicht aus einem Metallcarbid oder Metallnitrid, vorzugsweise aus Wolframcarbid oder Chromnitrid besteht.

6. Verfahren nach Anspruch 1, dadurch gekennzeichnet, daß die Abscheidung bei Temperaturen unterhalb von 250°C vorgenommen wird.

7. Verfahren nach Anspruch 1, dadurch gekennzeichnet, daß die Deckschicht durch ein Plasmaverfahren aufgebracht wird.

8. Verfahren nach Anspruch 7, dadurch gekennzeichnet, daß die Deckschicht durch Kathodenzerstäubung, Ionenplattieren, Arc-Beschichtung oder Plasmapolymerisation aufgebracht wird.

9. Verfahren nach Anspruch 1, dadurch gekennzeichnet, daß man den Grundkörper durch Wickelverfahren, Harzinjektionsverfahren oder Preßverfahren herstellt, ihn einer Konditionierung unterzieht und direkt anschließend die Deckschicht aufbringt.

10. Verfahren nach Anspruch 8, dadurch gekennzeichnet, daß die Konditionierung des Grundkörpers durch Aufheizen auf eine Temperatur oberhalb von 80°C in einer Inertgasatmosphäre und eine unmittelbar daran anschließende Plasmavorbehandlung erfolgt.

11. Formteile, hergestellt nach den Ansprüchen 1 bis 9.

12. Verwendung der Formteile nach Anspruch 10 als tribologisch beanspruchte Bauteile eines Apparates oder einer Maschine.